# EUROPEAN PATENT APPLICATION

(11) **EP 2 405 462 A1**
(43) Date of publication of application: **11.01.2012**
(21) Application number: 11172554.5
(22) Date of filing: 04.07.2011
(51) Int. Cl.: H01J 37/305, H01J 37/302, G01N 1/32

(54) **Method and system for preparing a sample**

(30) Priority: 06.07.2010 US 361536 P
(71) Applicant: Camtek Ltd., 23150 Migdal Haemek (IL)
(72) Inventor: Boguslavsky, Dimitry, 34361 Haifa (IL); SMITH, Colin, 37830 D.N. Menashe (IL)
(74) Representative: Modiano, Micaela Nadia

(57) **Abstract**

A system and method for preparing a sample (21), the method may include manipulating a mask (50) and a sample (21) and thereby exposing different sides of the sample to an ion miller (40). The manipulating may include rotating the mask and the sample while maintaining the spatial relationship between the sample and the mask unchanged.

## Description

### Related applications

This application claims priority from US provisional patent serial number

61/361,536, filing date July 6 2010, which is incorporated herein by reference.

### Field of the invention

The invention relates to methods and systems for preparing a sample for transmission electron microscopy.

### Background of the invention

Transmission electron microscopy (TEM) is a technique whereby a beam of electrons is transmitted through a thin sample, interacting with the specimen as it passes through. A high resolution image can be formed from the interaction of the electrons transmitted through the specimen. The thin sample can have a thickness of a few nano-meters.

The preparation of a TEM sample can start by receiving or manufacturing a sample that is connected to a sample holder element. The combination of the sample and the sample holder element, before being ion milled is referred to as an initial sample.

The sample holder element is much thicker than few microns and can be held by a manipulator. The sample holder element can be glued or otherwise connected to the sample. The edge area of the sample - or an area near the edge area of the sample can be thinned by a mechanical process and then be further thinned by an ion miller to provide a very thin area that can be transparent to electrons and can be used as a TEM sample.

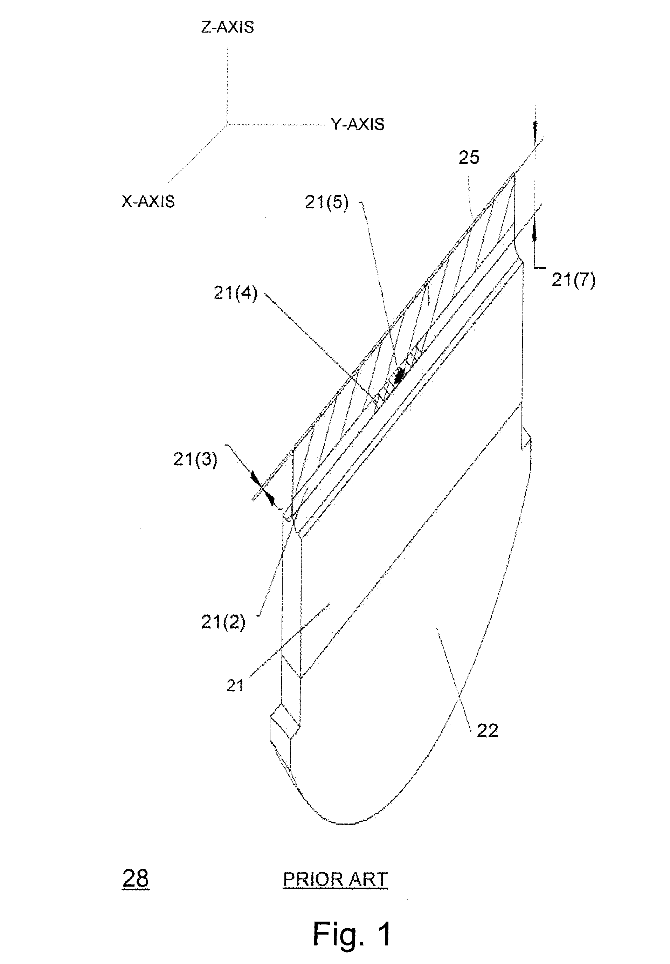

Figure 1 illustrates a prior art initial sample 21. The initial sample 21 includes a sample holder element 29 and a sample 28. The sample holder element 29 is shaped as a half of circle. The linear edge of the sample holder element 29 is connected to a first edge of the sample 28. The upper portion of the sample 28 is thinned to provide a pre-thinned area 21 (2) that ends with edge 25.

The pre-thinned area 21 (2) has a depth (height) 21(7) and a width 21(3). The pre-thinned area 21 (2) includes a area of interest 21 (4) that includes a target 21 (5) that should be included in the TEM sample.

There is a growing need to provide methods and systems for generating thin samples for Transmission electron microscopy.

### Summary

According to an embodiment of the invention a method for preparing a sample may be provided, The method may include:
a. Receiving, by a manipulator, a mask and an initial sample.
b. Positioning, by the manipulator, the mask and the initial sample in front of an imaging device so that the mask and a first side of an edge area of the initial sample face the imaging device.
c. Aligning, by the manipulator, the mask and the initial sample so that the mask masks a masked portion of the edge area of the initial sample while maintaining an exposed portion of the edge area of the initial sample unmasked. The aligning may include obtaining images of the mask and the initial sample by the imaging device.
d. Positioning, by the manipulator, the mask and the initial sample in front of an ion miller so that the mask and the first side of the edge area of the initial sample face the ion miller while unchanging a spatial relationship between the mask and the initial sample.
e. Milling, by the ion miller, the exposed portion of the edge area of the initial sample while masking the masked portion by the mask, to provide a partially milled sample.
f. Positioning, by the manipulator, the mask and the initial sample in front of the imaging device so that the mask and a second side of the edge area of the initial sample face the imaging device. The second side differs from the first side. The first and second sides can be opposite sides of the edge area.
g. Aligning, by the manipulator, the mask and the initial sample so that the mask masks a masked portion of the edge area of the partially milled sample while maintaining an exposed portion of the edge area of the partially milled sample unmasked. The aligning may include obtaining images of the mask and the partially milled sample by the imaging device.
h. Positioning, by the manipulator, the mask and the partially milled sample in front of the ion miller so that the mask and the second side of the edge area of the partially milled sample face the ion miller, while unchanging a spatial relationship between the mask and the partially milled sample.
i. Milling, by the ion miller, the exposed portion of the edge area of the partially milled sample while masking the masked portion by the mask, to provide a milled sample.

The positioning of the mask and the initial sample in front of the ion miller may include rotating the mask and the initial sample by the manipulator.

The milling of the exposed portion of the edge area of the partially milled sample may include monitoring a thickness of the edge area of the milled sample, during the milling, by a transmissive detector of the imaging device.

The method may include changing a spatial relationship between the mask and the partially milled based on thickness feedback information obtained during the milling of the edge area of the partially milled sample. Thus- the mask can be moved to expose a previously masked region of the mask area in order to remove the previously masked region and thereby thin the edge area to a required thickness.

The method may include changing a spatial relationship between the mask and the partially milled based on thickness feedback information obtained after the milling of the partially milled sample. Thus- the mask can be moved to expose a previously masked region of the mask area in order to remove the previously masked region and thereby thin the edge area to a required thickness.

The imaging device optical axis may be normal to a milling tool optical axis. The manipulator may rotate the mask and the initial sample by ninety degrees so that they face the ion miller.

The method may include:
a. Positioning, by the manipulator, the mask and the initial sample so that the mask and the first side of the edge area of the initial sample are normal to an optical axis of the imaging device.
b. Positioning, by the manipulator, the mask and the initial sample in front of an ion miller so that the mask and the first side of the edge area of the initial sample are normal to an optical axis of the ion miller.
c. Positioning, by the manipulator, the mask and the initial sample in front of the imaging device so that the mask and the second side of the edge area of the initial sample are normal to an optical axis of the imaging device. and
d. Positioning, by the manipulator, the mask and the partially milled sample in front of the ion miller so that the mask and the second side of the edge area of the partially milled sample are normal optical axis of the ion miller.

The edge area of the initial sample may have a thickness of at least one micros and wherein thickness of the edge area of the milled sample does not exceed 50 nanometers.

The milling may include milling the sample while rotating a milling beam about the optical axis of the ion miller.

The method may include removing, by ion milling, the exposed portion of the edge area of the partially milled sample.

The method may include stopping the milling of the edge area of the partially milled sample based on a thickness of the edge area of the partially milled sample.

The method may include monitoring the thickness of the edge area of the partially milled sample by a transmissive detector of the imaging device.

The method may include comparing a current outputted by a transmissive detector of the imaging device to a predefined relationship between current values and thickness values.

The method may include:
a. Positioning, by the manipulator, the mask and the milled sample in front of the imaging device so that the mask and the first side of an edge area of the milled sample face the imaging device.
b. Aligning, by the manipulator, the mask and the milled sample so that the mask masks a masked portion of the edge area of the milled sample while maintaining an exposed portion of the edge area of the milled sample unmasked. The aligning may include obtaining images of the mask and the milled sample by the imaging device.
c. Positioning, by the manipulator, the mask and the milled sample in front of the ion miller so that the mask and the first side of the edge area of the milled sample face the ion miller; while unchanging a spatial relationship between the mask and the milled sample.
d. Milling, by the ion miller, the exposed portion of the edge area of the milled sample while masking the masked portion by the mask, to provide a further milled sample.

The obtaining of images can be executed by an imaging device that is an optical device, a scanning electron microscope or a combination of an optical device and a scanning electron microscope.

The method may include monitoring a progress of the milling of the initial sample by a backscattered electron detector; and monitoring a completion of a milling of the partially milled sample by a transmissive detector.

The method may include automatically stopping the milling of the partially milled sample when reaching a desired thickness of the edge area of the partially milled sample.

According to an embodiment of the invention a sample preparation system is provided and may include a manipulator, an imaging device; and an ion miller.
a. The manipulator may be arranged to:
   1. Receive a mask and an initial sample.
   2. Position the mask and the initial sample in front of an imaging device so that the mask and a first side of an edge area of the initial sample face the imaging device.
   3. Participate in an alignment of the mask and the initial sample so that the mask masks a masked portion of the edge area of the initial sample while maintaining an exposed portion of the edge area of the initial sample unmasked. The manipulator participates in the alignment process as it positions the mask and the initial sample at required positions. The alignment process may further require an acquisition of images of the mask and the initial sample, a processing of the images and an provision of commands (from an operator, from a controller, manually or automatically) to the manipulator.
   4. Position the mask and the initial sample in front of an ion miller so that the mask and the first side of the edge area of the initial sample face the ion miller; while unchanging a spatial relationship between the mask and the initial sample.
b. The ion miller may be arranged to mill the exposed portion of the edge area of the initial sample while masking the masked portion by the mask, to provide a partially milled sample.
c. The manipulator is further arranged to:
   1. Position the mask and the initial sample in front of the imaging device so that the mask and a second side of the edge area of the initial sample face the imaging device; wherein the second side differs from the first side.
   2. Participate in an alignment of the mask and the partially milled sample so that the mask masks a masked portion of the edge area of the partially milled sample while maintaining an exposed portion of the edge area of the partially milled sample unmasked. The manipulator participates in the alignment process as it positions the mask and the partially milled sample at required positions. The alignment process may further require an acquisition of images of the mask and the partially milled sample, a processing of the images and an provision of commands (from an operator, from a controller, manually or automatically) to the manipulator.
   3. Position the mask and the partially milled sample in front of the ion miller so that the mask and the second side of the edge area of the partially milled sample face the ion miller, while unchanging a spatial relationship between the mask and the partially milled sample.
d. The ion miller may be further adapted to mill the exposed portion of the edge area of the partially milled sample while masking the masked portion by the mask, to provide a milled sample.
e. The imaging device may be arranged to:
   1. Obtain images of the mask and the initial sample during the alignment of the mask and the initial sample.
   2. Obtain images of the mask and the partially milled sample during the alignment of the mask and the partially milled sample.

The imaging device may be an optical device, a scanning electron microscope or a combination thereof.

The system manipulator may be arranged to rotate the mask and the initial sample until the mask and the initial sample face the ion miller.

The imaging system may include a transmissive detector that may be arranged to provide detection signals indicative of a thickness of the exposed portion of the edge area of the partially milled sample, during a milling of the exposed portion of the edge area of the partially milled sample.

The manipulator may be arranged to change a spatial relationship between the mask and the partially milled based on thickness feedback information obtained during a milling of the edge area of the partially milled sample.

The system may include wherein the manipulator may be arranged to change a spatial relationship between the mask and the partially milled based on thickness feedback information obtained after a milling of the partially milled sample.

The imaging device optical axis may be normal to a milling tool optical axis; and wherein the manipulator may be arranged to rotate the mask and the initial sample until the mask and the initial sample face the ion miller.

The manipulator may be arranged to:
a. Position the mask and the initial sample so that the mask and the first side of the edge area of the initial sample are normal to an optical axis of the imaging device.
b. Position the mask and the initial sample in front of an ion miller so that the mask and the first side of the edge area of the initial sample are normal to an optical axis of the ion miller.
c. Position the mask and the initial sample in front of the imaging device so that the mask and the second side of the edge area of the initial sample are normal to an optical axis of the imaging device.
d. Position the mask and the partially milled sample in front of the ion miller so that the mask and the second side of the edge area of the partially milled sample are normal optical axis of the ion miller.

The edge area of the initial sample may have a thickness of at least one micros and wherein the system may be arranged to mill the edge area of the milled sample until a thickness of the edge area of the milled sample does not exceed 50 nanometers.

The ion miller may be arranged to mill while rotating a milling beam about the optical axis of the ion miller.

The ion miller may be arranged to remove the exposed portion of the edge area of the partially milled sample.

The system may include a controller that may be arranged to stop a milling of the edge area of the partially milled sample based on a thickness of the edge area of the partially milled sample.

The system may include a transmissive detector that may be arranged to assist in a monitoring of a thickness of the edge area of the partially milled sample. The transmissive detector assists in the monitoring by providing detection signals that are indicative of the thickness of the edge area of the sample. The detection signals represent known thicknesses and thus can be processed to detect the actual thickness of the edge area.

The system may include a controller that may be arranged to compare a current outputted by the transmissive detector of the imaging device to a predefined relationship between current values and thickness values.

The system may include a backscattered electron detector arranged to participate in a monitoring of a progress of a milling of the initial sample; and a transmissive detector that may be arranged to assist in a monitoring of a completion of a milling of the partially milled sample.

The system may include a controller that may be arranged to automatically stop a milling of the partially milled sample when reaching a desired thickness of the edge area of the partially milled sample.

The ion miller may be further arranged to mill the exposed portion of the edge area of the milled sample while the masked portion is being masked by the mask, to provide a further milled sample.

The manipulator may be further arranged to:
a. Position the mask and the milled sample in front of the imaging device so that the mask and the first side of an edge area of the milled sample face the imaging device.
b. Participate in an alignment of the mask and the milled sample so that the mask masks the masked portion of the edge area of the milled sample while maintaining an exposed portion of the edge area of the milled sample unmasked.
c. Position the mask and the milled sample in front of the ion miller so that the mask and the first side of the edge area of the milled sample face the ion miller; while unchanging a spatial relationship between the mask and the milled sample.

### Brief description of the drawings

Further details, aspects and embodiments of the invention will be described, by way of example only, with reference to the drawings. In the drawings, like reference numbers are used to identify like or functionally similar elements. Elements in the figures are illustrated for simplicity and clarity and have not necessarily been drawn to scale.

Figure 1 illustrates a prior art initial sample;

Figure 2 illustrates a portion of a system during an alignment stage according to an embodiment of the invention;

Figure 3 illustrates a portion of a system during a first milling sequence according to an embodiment of the invention;

Figure 4 illustrates a portion of a system during a second milling sequence according to an embodiment of the invention;

Figure 5 illustrates a milled sample according to an embodiment of the invention;

Figure 6 illustrates a manipulator according to an embodiment of the invention;

Figure 7 illustrates a sample holder, an initial sample and a portion of the manipulator according to an embodiment of the invention;

Figure 8 illustrates a sample holder according to an embodiment of the invention;

Figure 10 illustrates a system according to an embodiment of the invention;

Figures 11A-11C illustrate portions of a system according to various embodiment of the invention;

Figure 12 illustrates an ion miller according to an embodiment of the invention;

Figure 13A-13D illustrate air lock assemblies according to various embodiments of the invention;

Figure 14 illustrates a method according to an embodiment of the invention; and

Figure 15 illustrates a method according to an embodiment of the invention.

### Detailed description of the drawings

The foregoing and other objects, features, and advantages of the present invention will become more apparent from the following detailed description when taken in conjunction with the accompanying drawings. In the drawings, similar reference characters denote similar elements throughout the different views.

Because the illustrated embodiments of the present invention may for the most part, be implemented using electronic components and circuits known to those skilled in the art, details will not be explained in any greater extent than that considered necessary for the understanding and appreciation of the underlying concepts of the present invention and in order not to obfuscate or distract from the teachings of the present invention.

The term edge area may have its regular meaning. It may be interpreted as being an area that is proximate to an edge or may be delimited by an edge. An edge area of a sample can be proximate to the edge of the sample or delimited by the edge. It may include a target. The edge area of the sample can be thinned by ion milling to form a TEM sample. The thickness of the edge area, after milling can be below 51 nanometers. Its width and length can exceed one or more microns, but other dimensions can be provided. The edge area is illustrated as having a rectangular shape but this is not necessarily so and it can have other shapes.

According to an embodiment of the invention a method is provided. The method may include:
a. Generating or receiving a mask. The mask can be manufactured by micro-cleaving process to provide a highly accurate mask.
b. Receiving or generating an initial sample that has a thickness (near its edge) of few microns. Referring to the example set forth in figure 1, the thickness of the initial sample is the thickness of the pre-thinned area 21(2).
c. Providing the mask and the initial sample to a manipulator. Referring to the example set forth in figure 1, the manipulator holds the sample holder element 29.
d. Aligning the mask and the initial sample by using a manipulator and viewing the alignment process by a scanning electrons microscope, an optical microscope or a combination thereof. The alignment process can include moving one or more out of the mask and the initial sample along one or more axes until a desired spatial relationship is achieved. For example- the alignment may include positioning the mask and the initial sample until they are parallel to each other and the mask unmasks only a portion of the initial sample that should be removed. Referring to the initial sample of figure 1, the mask can be positioned so that the edge area of the mask will be parallel to edge 25 (along the X-axis) and it will mask just more than a half of the pre-thinned area. The slight deviation from the exact half of the pre-thinned image is about one half of the expected width of the TEM sample. The TEM sample may have the same depth as the pre-thinned area. Alternatively - the masking element of figure 1 can be at least partially removed before performing the milling.
e. Rotating the mask and the initial sample about an axis while maintaining the alignment so that the mask and initial sample face an ion miller. The mask and the initial sample face the ion miller in the sense that they are positioned in the field of view of the ion miller. They can be normal to the optical axis of the ion miller but may be oriented in angles that differ from ninety degrees from the optical axis. If the ion miller changes the illumination angle during the milling process the optical axis of the ion miller can be defined to be a function of the different milling angles. For example, the optical axis can be the average of the different milling angles.
f. Performing a first milling sequence that includes milling the exposed portion of the edge area of the initial sample by the ion miller, the ion miller can mill by a dual deflection technique while observing the milling by the scanning electron microscope.
g. Changing the spatial relationship between the mask and the partially milled sample (by the manipulator) in order to expose the other side of the edge area of the partially milled sample to the ion miller.
h. Aligning the mask and the partially milled sample by using the manipulator, and at least one out of the scanning electron microscope and the optical microscope. The mask is aligned to expose the other side of the partially milled sample to ion milling, and alignment may include moving the mask and/or the initial sample by the manipulator.
i. Performing a second milling sequence that includes milling the other (now exposed) portion of the edge area of the partially milled sample by the ion miller while observing the milling by the scanning electron microscope until reaching a desired thickness.

The system can view the sample continuously and in a real time mode during the entire milling process and may have a fully automatic control of the process accuracy, quality and termination.

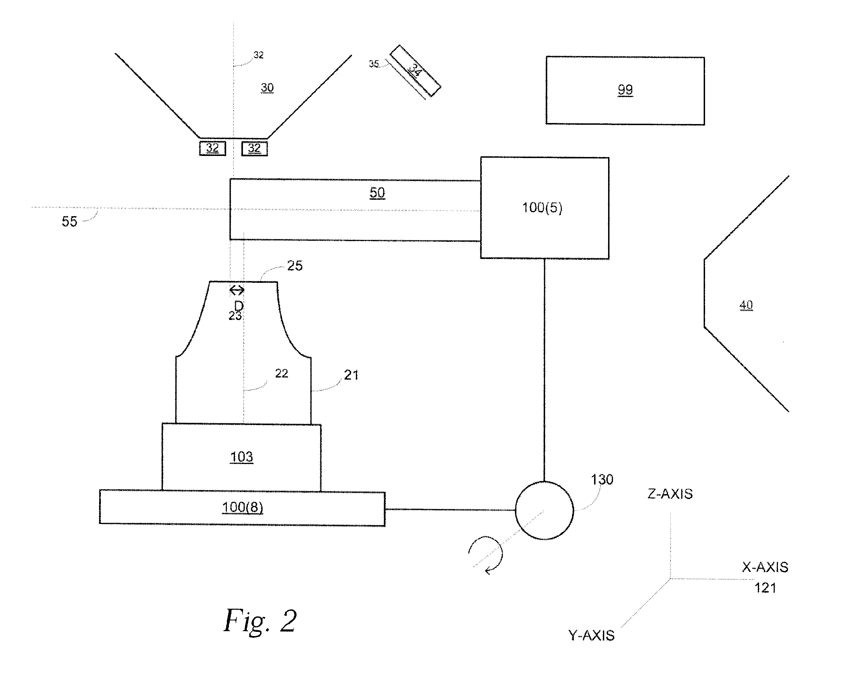

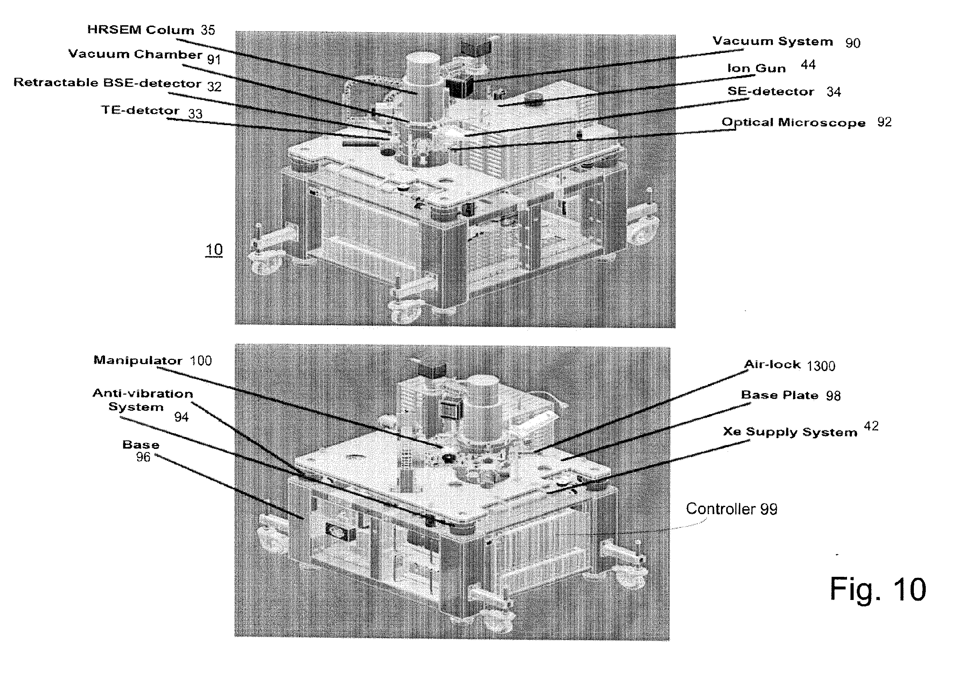

Referring to figures 2-4 and 10, the system 10 may include:
a. A manipulator 100. The manipulator 100 may include multiple manipulating elements various stages.
b. An imaging device such as a scanning electron microscope (SEM). The SEM may include, for example, an objective lens 30, BSE detector 32, SE detector 34, TEM detector 33 as well as an electron source, electron optics and other components that may be included in a SEM column 35.
c. An ion miller 40.
d. A controller (denoted 99 in figure 10) that controls the different components of the system.

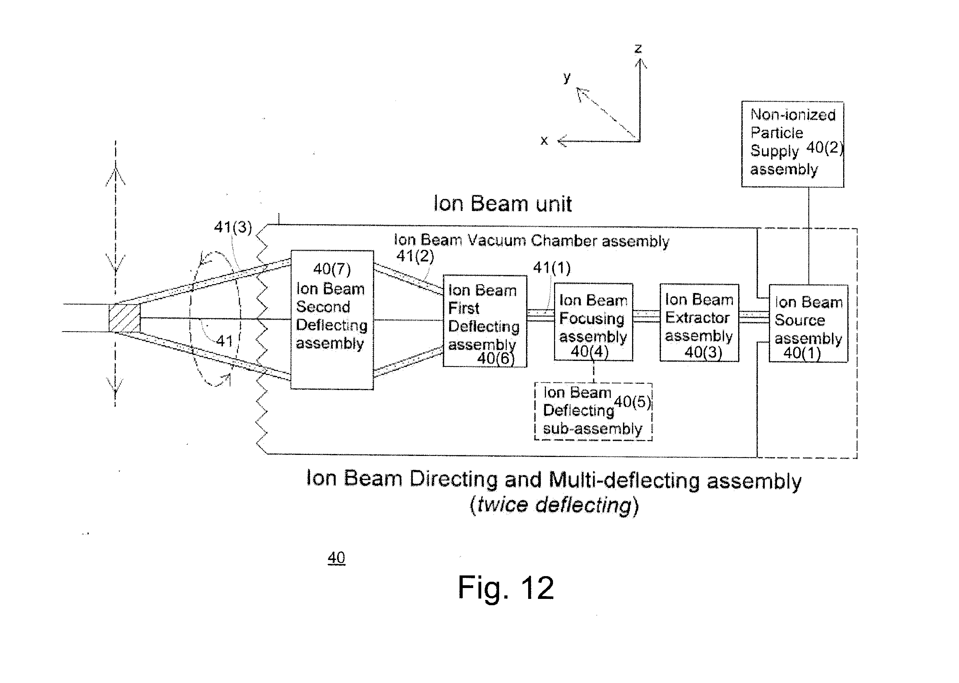

The system 10 may also include a vacuum system 90, a vacuum chamber 91, optical microscope 92, anti-vibration system 94, base 96, air-lock 1300 and a base plate 98. The ion beam unit 40 may include various components (some are illustrated in figures 10 and 12) such as a Xe supply unit 42 and an ion gun 44.

The system 10 may generate or receive a mask 50. The mask can be manufactured by micro-cleaving to provide a highly accurate mask. If the system generates the mask 50 then it includes a micro-cleaving unit (not shown).

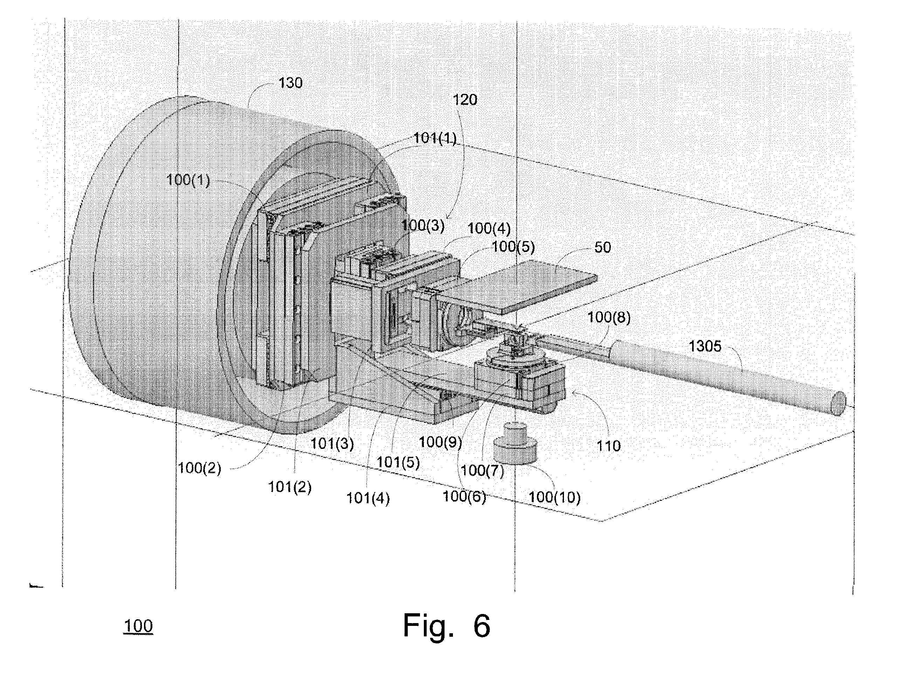

Figure 6 illustrates a manipulator 100 and a part of a feeding rod 1305 of an air-lock 1300.

The manipulator 100 includes two separate subunits 110 and 120 both located on a main rotating stage 130.

The second subunit 120 may manipulate the sample and the mask and may have X, Y, Z and θ stages. In figure 6 these stages are denoted as follows : X-stage 100(1), Y-stage 100(2), Z-stage 100(3) and θ stage 100(5).

The first subunit 110 may manipulate the sample - it may change the spatial relationship between the mask and the sample - for example by moving the mask in relation to any movement introduced by the second sub-unit 120. It is noted that each of the mask and sample can be moved by sub-units - each can move in relation to each other and not share stages such as rotating stage 130.

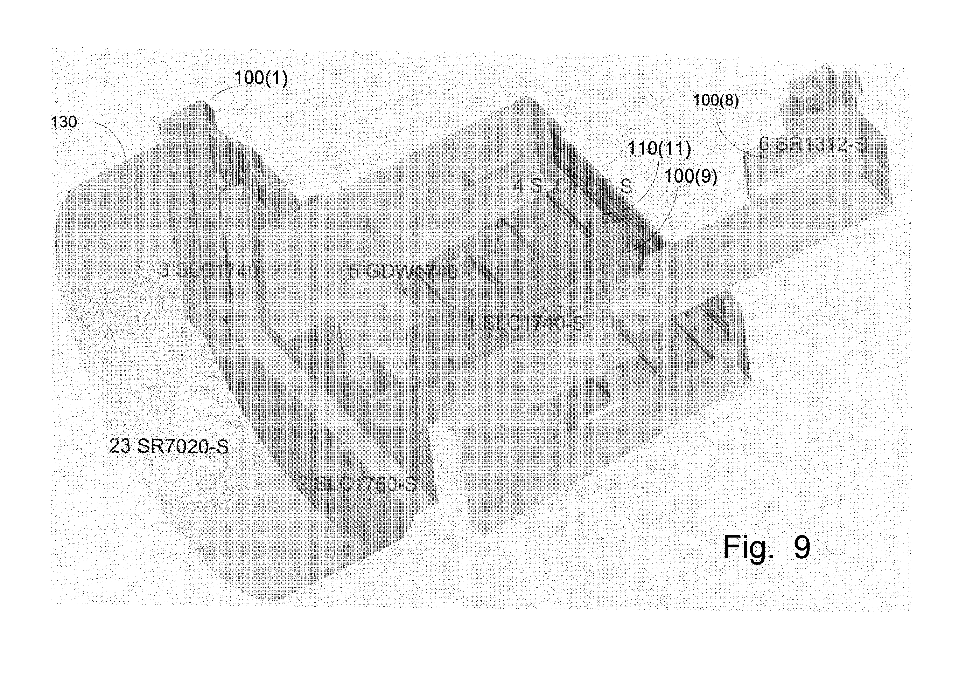

The first subunit 110 may have X, Y, Z and θ stages. In either one of figures 6 and 9 these stages are denoted as follows: X-stage 100(11), Y-stage (not shown), Z-stage 100(9), and θ stage 100(8).

The second subunit 120 may manipulates the mask and may also manipulate technological accessories such as mask, calibrating plate, apertures, target for deposition etc.

The first subunit 110 may receive the sample or technological accessories from a sample holder (also referred to as shuttle 103). The shuttle 103 may be transferred until it is positioned on the sample angular stage 100(8).

The stages are connected between structural elements such as plates, beams, rails, guidelines and the like denoted 101(1)- 101(5).

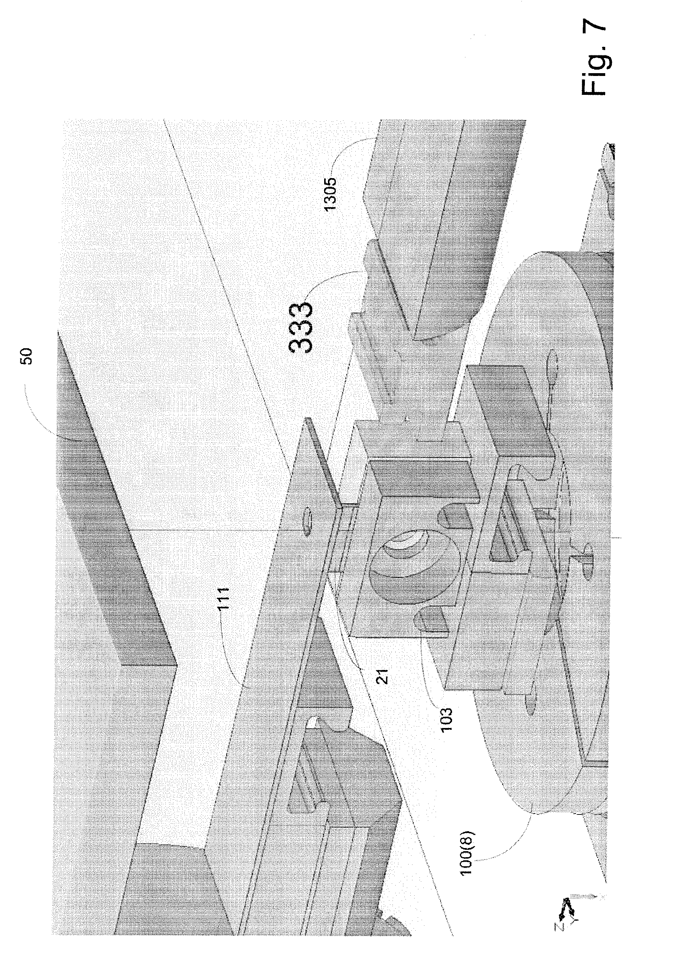

Figure 7 illustrates in greater details the initial sample 21 that is held by shuttle 103, masked by mask 50. Figure 7 also illustrates a fixed aperture mask 111 positioned above the initial sample 21. The ion beam should pass through the aperture of the fixed aperture mask 111. The fixed aperture mask 111 prevents collateral damage resulting from the ion milling. It is fixed in relation to the initial sample 21. Figure 7 also shows an element 333 that may support the initial sample 21 when the initial sample provided from (or to) the lock load. Figure 7 illustrates the element 333 after the initial sample 21 is taken and placed on shuttle 103.

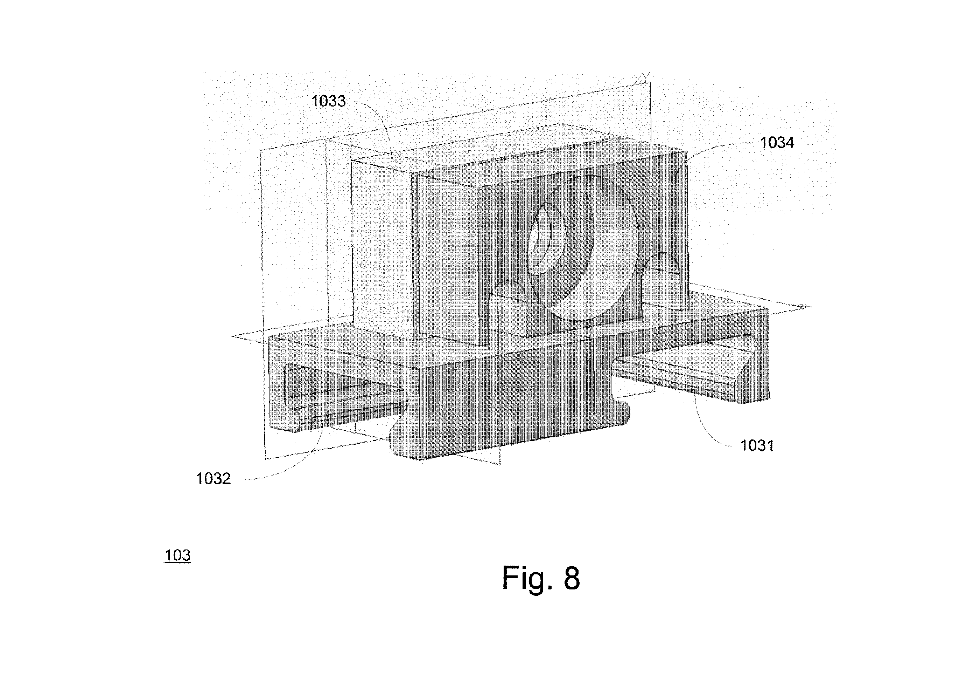

Figure 8 illustrates a shuttle 103 that includes two co-perpendicular dove-tails 1031 and 1032. The shuttle 103 also includes two spaced apart blocks 1033 and 1034 that hold the sample 21 in the narrow space between them. Figure 9 illustrates various structural elements as well as manipulator engines 131.

Referring to figure 2, the scanning electron microscope, using detector 32 and/or detector 34 is used to monitor an alignment process between the initial sample 21 and the mask 50.

The alignment process may include aligning the mask 50 and the initial sample 21 so that (a) they are parallel to each other (both can be horizontal) or be positioned on any other manner, and (b) the edge area of the mask 50 is positioned directly above an imaginary line that represents a desired milled edge of the initial sample 21 after being milled during a first milling sequence. This imaginary line can be located few nanometers from a center of the milled sample 21. Dashed line 55 illustrates that the mask 50 is horizontal at the end of the alignment process. The distance (D 23) between a trajectory of the edge 53 of the mask 50 on the edge 25 of the initial sample 21 and the center 22 of the initial sample 31 is few nano-meters. It is about a half of the final thickness of the milled sample.

The alignment process is aimed to guarantee that once the mask is placed between an ion miller and the initial sample 21, it (the mask) will prevent the ion miller from milling a pre-defined masked portion of the initial sample while allowing the ion miller to mill a pre-defined exposed portion of the initial sample.

Once the alignment process ends the mask 50 and the initial sample 21 are moved (for example - rotated). The rotation can be executed by the main rotating stage 130 and about an axis (for example- about the X axis), while maintaining the spatial relationship between the mask 50 and the initial sample 21 unchanged. The movement (rotation) can be stopped once the mask 50 and the initial sample 21 face the ion miller 40.

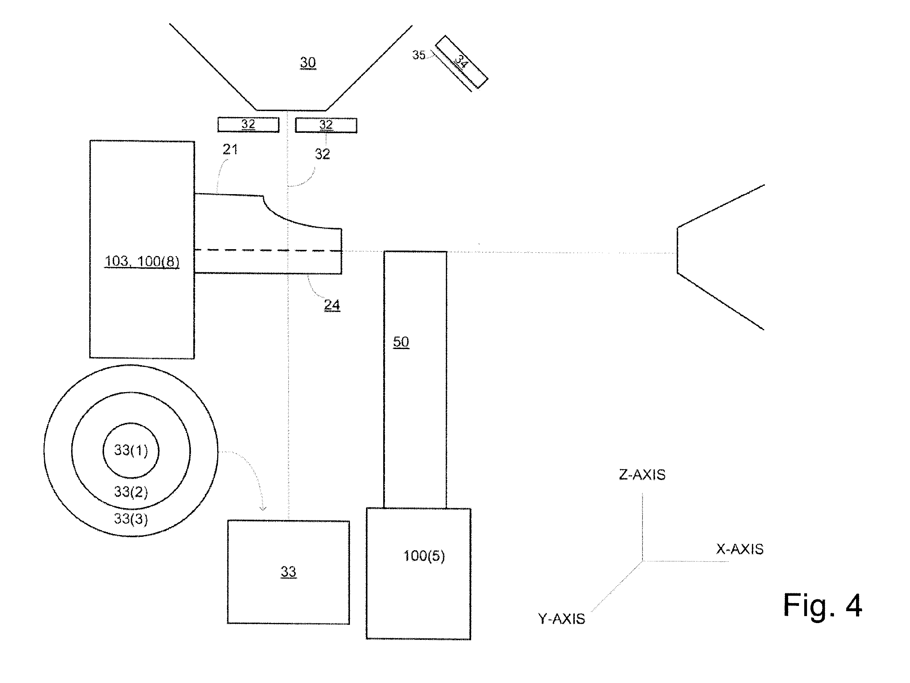

The ion miller 40 performs a first milling sequence that may include milling the exposed portion of the edge area of the initial sample 21 by a dual deflection while observing the milling by the scanning electron microscope (using detector 32 and/or detector 34). The milling may further thin the pre-thinned area of the initial sample 21 on one side to provide a milled side (denoted 24 in figure 4) of a partially milled sample (denoted 21' in figure 4). The ion beam 42 can be deflected within the X-Y plane, but this is not necessarily so.

After one side of the initial sample is milled (to provide partially milled sample 21') the manipulator 100 changes the spatial relationship between the mask 50 and the partially milled sample 21' in order to expose the other side of the edge area of the partially milled sample 21' to the ion miller 40. This may include rotating the partially milled sample 21' about its axis (112) by the sample rotational stage 100(8), and may also include changing the height of the mask 50.

According to an embodiment of the invention the change of spatial relationship is controlled during an alignment process during which the imaging system acquired images of the mask and the partially milled sample to guarantee that the desired alignment is obtained. The alignment may be preceded by moving (for example-rotating) that mask and the partially milled sample until they face the imaging system, performing the alignment and then moving (for example- rotating) the mask and the partially milled sample till they face the ion miller.

After the spatial relationship is changed, the ion miller 40 performs a second milling sequence that includes milling the other (now exposed) portion of the edge area of the partially milled sample 21' while observing the milling by the scanning electron microscope and (optionally - when the partially milled sample starts to be partially transparent to electrons) by a TEM or STEM detector 33, until reaching a desired thickness. The milling process can be automatically stopped when the TEM detector 33 indicates that the thickness of the milled sample reached the desired thickness.

The system 10 can include a retractable BSE detector, a SE detector or a combination thereof. During initial ion milling at high sputtering rate, the viewing of the sample can be accomplished by the retractable BSE detector 32 that is illustrated in figure 2 as being located beneath the pole pieces of the objective lens 30.

To obtain high-resolution images at intermediate stages of ion milling when the sample is yet not transparent for incident primary electrons, a combination of SE detector 34 and BSE detector 32 can be used.

To obtain high-resolution images at final stages of ion milling when the sample becomes transparent for primary electrons a transmissive (TE) detection is used. A target identification for the sample alignment process can be carried out by operator by means of a combination of the three above-mentioned detectors; SE, BSE and TE.

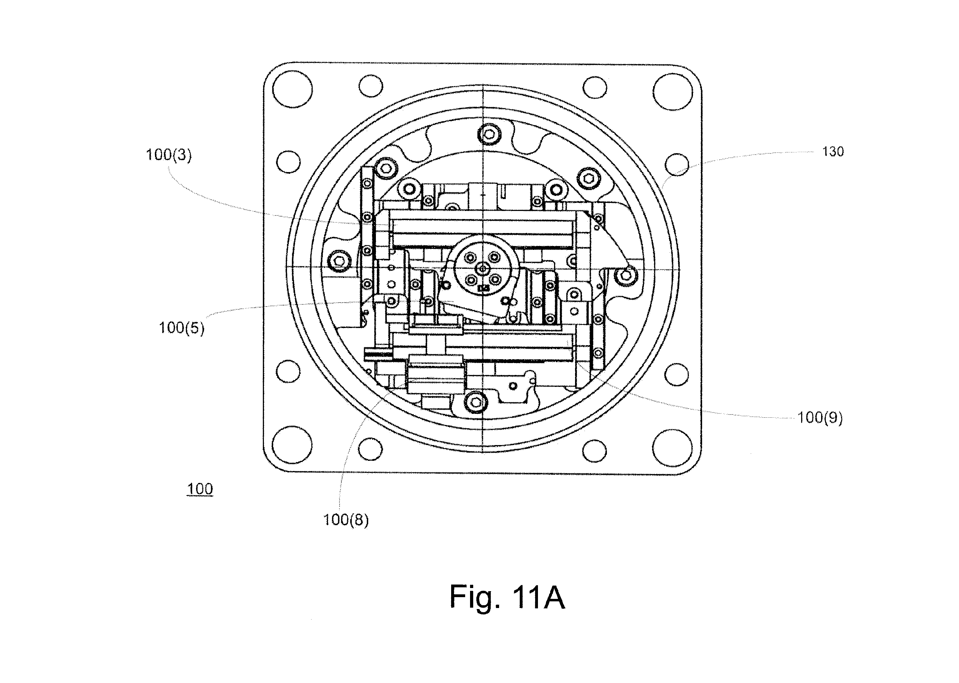

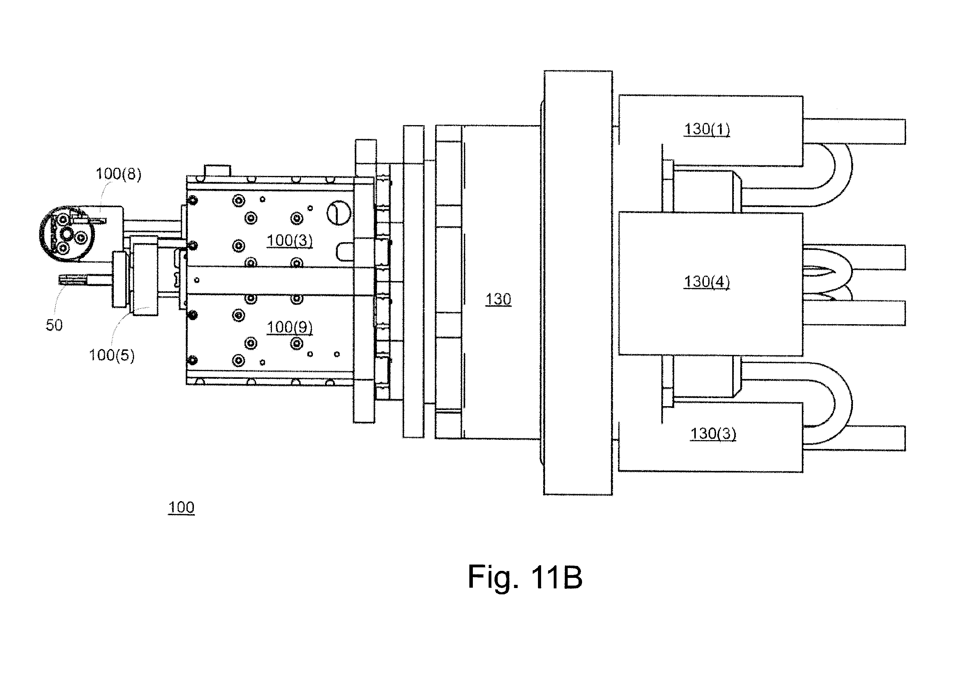

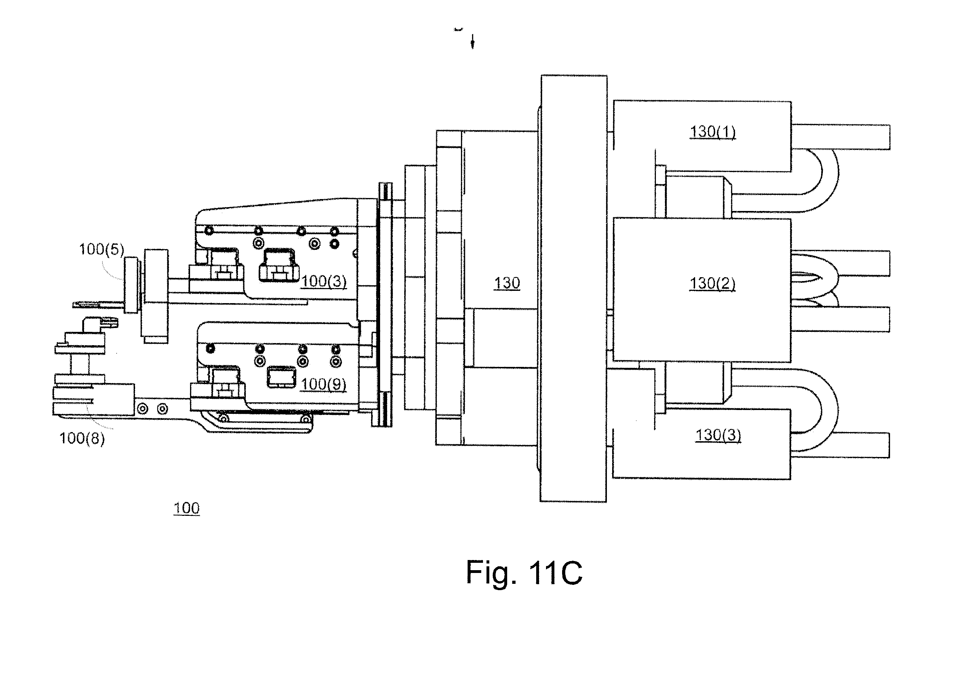

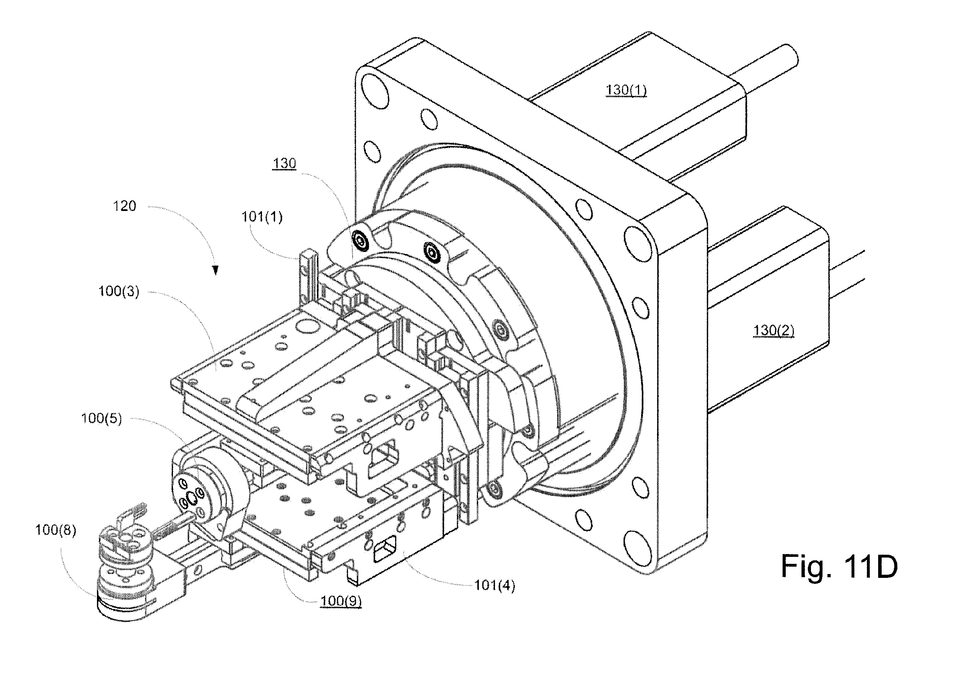

The final thickness of the milled sample 21" can be determined by measurement of output currents from a transmissive (TE) detector 33. Calibration curves of these output currents versus the sample thickness will be calculated for the predefined analytical conditions for different material constituents of the sample. An example of such a curve is illustrated in figure 11. These curves are an additional output of the detector data is to automatically terminate the milling process. The thickness map will be provided along with the finished TEM sample.

The SE detector 34 can be an Everhart-Thornley type detector that includes a combination of a scintillator and a photo-multiplier. The SE detector 34 can be mounted on the sidewall of the system chamber. The SE detector 34 can operate in a current mode. During ion milling the SE detector 34 is protected by a protective shutter 35. Figure 2 illustrates the SE detector 34 as being located at the right side of the objective lens 30, but this is not necessarily so.

The BSE detector 32 can be a solid-state semiconductor detector, which can be located beneath the pole pieces of the objective lens 30 to allow its retracting in order to obtain high resolution observation mode when extremely short working distance is needed. The BSE detector 32 can operate in a current mode. The BSE 32 detector can be used during ion milling for observation of the sample surface.

The TE detector 33 may include three independent parts, which are electrically isolated one from another. A first part - referred to as a first bright field TE 33(1) detector may be a disk located on the microscope principal axis beneath the sample. It is dedicated to detection of transmitted electrons scattered at small angles. The second part is referred to as a second bright field TE detector 33(2) represents a ring coaxial with the first bright field TE detector. It is dedicated to detection of transmitted electrons scattered at small angles but bigger than for first bright field TE-detector. The third part - referred to as dark field TE detector 33(3) represents a ring coaxial with the second bright field TE detector. It is dedicated to detection of transmitted electrons scattered at relatively large angles. All three of these TE detector parts can be solid-state semiconductor detectors can have an atomic number resolution that equals to approximately 1 and can work in a current mode. During ion milling the TE detector 33 can be protected by a protective shutter Faraday cup located on its top on the microscope principal axis beneath the sample 21. It can be dedicated to measure electron probe current in order to provide subsequent calibration of the TE-detector for thickness measurement of a treated sample.

It is noted that the number of detectors, their location, the types of detectors and the number of parts of each detector (As well as their size and shape) can differ from the example illustrated above.

Figures 11A-11C illustrate a manipulator 100 according to various embodiment of the invention. Figure 11A is a front view of the manipulator 100, figure 11B is a top view of the manipulator 100, figure 11C is a side view of the manipulator 100 and figure 11D is a three-dimensional view of the manipulator 100, all according to an embodiment of the invention.

The manipulator 100 includes two separate subunits 110 and 120 both located on a main rotating stage 130. The rotating stage 130 is separated by and powered by engines 130(1) - 130(4).

The second subunit 120 may manipulate the sample and the mask and may have X, Y, Z and θ stages. In figure 6 these stages are denoted as follows : X-stage 100(1), Y-stage 100(2), Z-stage 100(3) and θ stage 100(5).

The first subunit 110 may manipulate the sample - it may change the spatial relationship between the mask and the sample - for example by moving the mask in relation to any movement introduced by the second sub-unit 120. It is noted that each of the mask and sample can be moved by sub-units - each can move in relation to each other and not share stages such as rotating stage 130.

The first subunit 110 may have X, Y, Z and θ stages. In either one of figures 6 and 9 these stages are denoted as follows: X-stage 100(11), Y-stage (not shown), Z-stage 100(9), and θ stage 104(8).

The second subunit 120 may manipulates the mask and may also manipulate technological accessories such as mask, calibrating plate, apertures, target for deposition etc.

The first subunit 110 may receive the sample or technological accessories from a sample holder (also referred to as shuttle 103). The shuttle 103 may be transferred until it is positioned on the sample angular stage 100(8).

The stages are connected between structural elements such as plates, beams, rails, guidelines and the like denoted 101(1) - 101(5).

Referring to figure 12, the ion miller 40 (also referred to as ion sputtering system) can have the following capabilities and degrees of freedom:
a. Wide range of ion energy control to allow quick bulk removal to intensify the process as well as gentle milling mode to provide highest level of the final quality of a treated sample.
b. High ion current density for short process duration.
c. Control of ion current uniformity along beam cross section to provide uniform treatment of a sample.
d. Variable incidence angle of the beam relatively to the sample surface to avoid selective milling of the sample surface.
e. Control of the beam shape and size to provide variety of applications and technological modes.
f. Beam pulsating for uniformity of sample treatment.
g. Beam accurate positioning to provide specific area of a sample treatment.
h. Beam scanning in orthogonal directions for uniformity of sample treatment.
i. Eu-centric beam rotation around area of interest for uniformity of sample treatment.

The ion miller 40 may include:
a. Duo-plasmatron ion source to ignite the plasma.
b. Beam formation module to extract and collect Xe+ ion beam from the plasma.
c. Final optics to focus and direct ion beam toward a treated sample.
d. Xe gas supply system to provide an automatic gas delivery of constant and specified pressure.
e. Leak-valve that provides automatic supply of metering amount of the gas into the ion source for plasma ignition and ion beam formation.
f. Electronics and power supplies to provide automatic control of the ion sputtering system.

Figure 12 illustrates the ion miller 40 as including a ion beam source assembly 40(1), a non-ionized particle supply assembly 40(2), an ion beam extractor assembly 40(3), an ion beam focusing assembly 40(4), an ion beam deflecting sub-assembly 40(5), a ion beam first deflecting assembly 40(6), and an ion beam second deflecting assembly 40(7).

The ion beam source assembly 40(1) is fed by the non-ionized particle supply assembly 40(2) and the ion beam extractor assembly 40(3) outputs an ion beam that propagates along an optical axis 41 of the ion miller. The ion beam focusing assembly 40(4) focuses the ion beam and feeds the focused ion beam to ion beam first deflecting assembly 40(6) that rotates the ion beam and directs it along directions that are spaced apart from the optical axis of the ion miller to provide deflected and rotated ion beam 41(2). The ion beam second deflecting assembly 40(7) directs the rotating ion beam towards the optical axis, while maintaining the rotation of the ion beam 41(3). The rotation constantly changes milling angle and provide a smoother milled sample.

A non limiting example of an ion miller is provided in US patent application publication serial number 2008/0078750A1 titled "Directed Multi-Deflected Ion Beam Milling of a Work Piece and Determining and Controlling Extent Thereof", which is incorporated herein by reference.

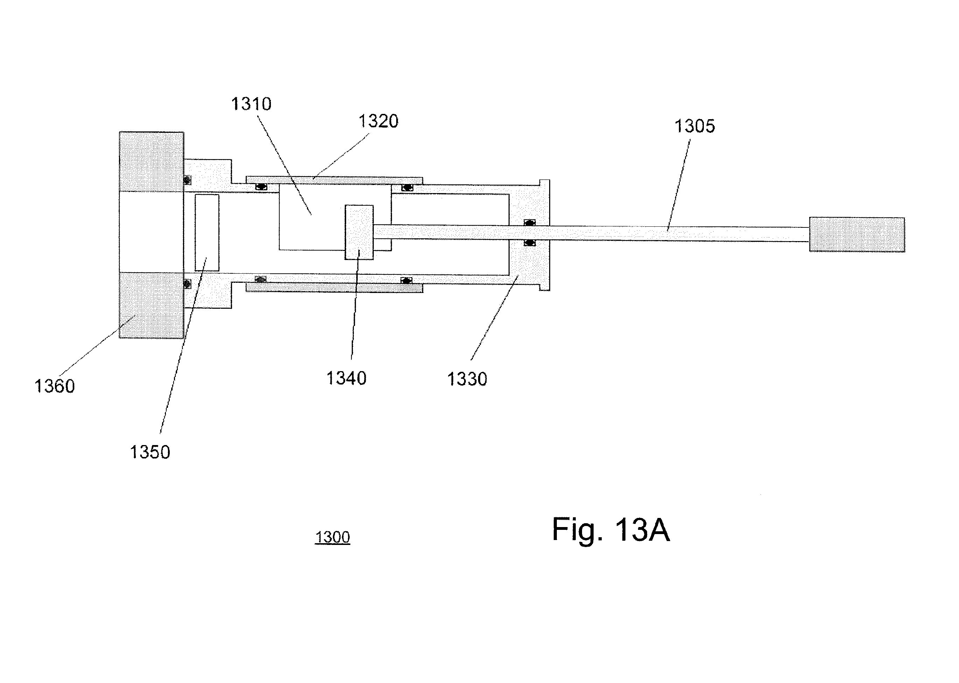

Referring to figures 13A-13D, the system has an air-lock 1300. Figure 13A is a schematic cross section of a air lock 1300 and wall 91 (1) of a vacuum chamber 91 according to an embodiment of the invention.

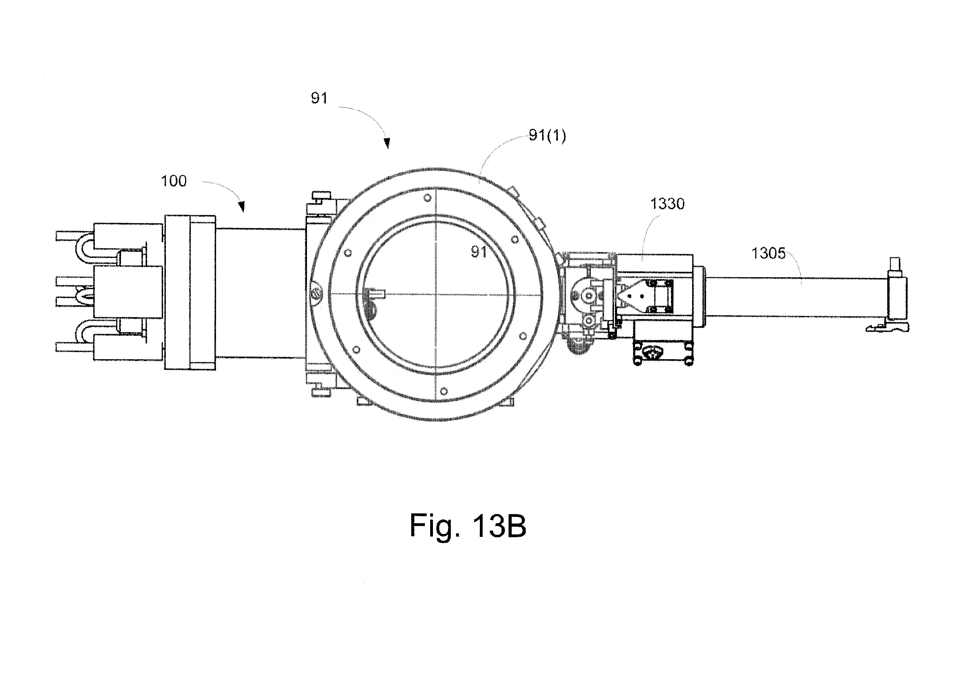

Figure 13B is a top view of a air lock 1300, a vacuum chamber 91 and a manipulator 100 according to an embodiment of the invention. Figure 13B illustrates the air lock before the sample supported by the feeding rod is entered to the vacuum chamber 91.

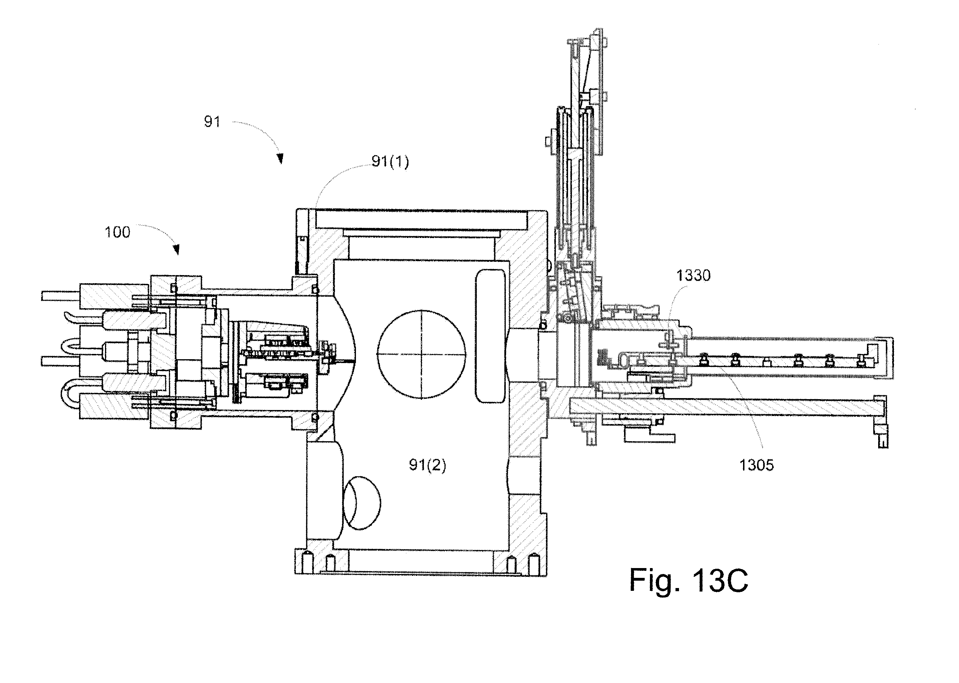

Figure 13C is a cross sectional view of a air lock 1300, a vacuum chamber 91 and a manipulator 100 according to an embodiment of the invention. Figure 13C illustrates the air lock before the sample supported by the feeding rod is entered to the vacuum chamber 91.

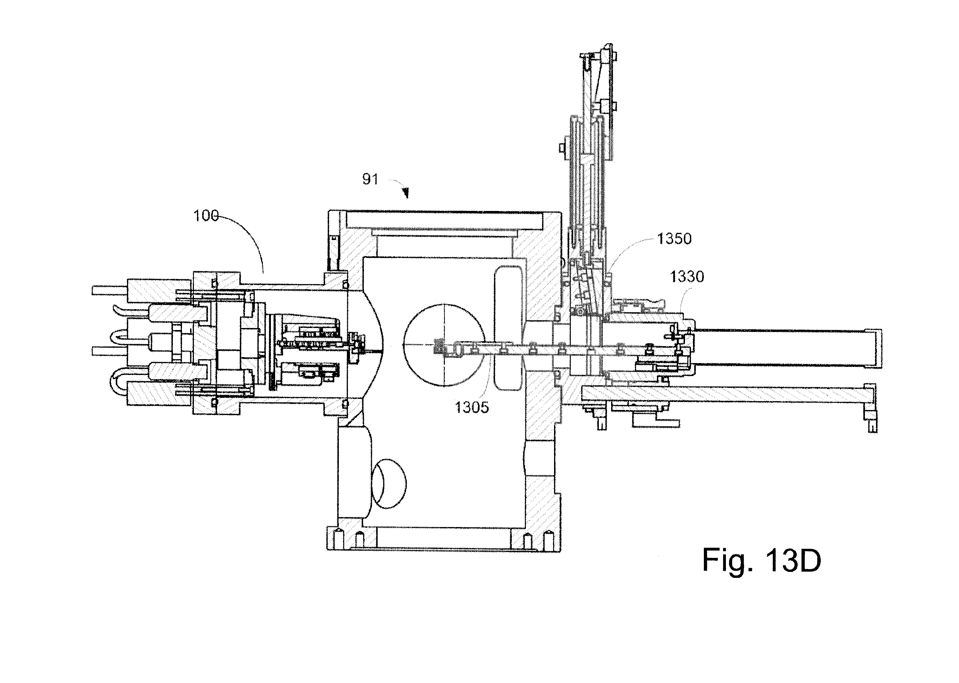

Figure 13D is a cross sectional view of a air lock 1300, a vacuum chamber 91 and a manipulator 100 according to an embodiment of the invention. Figure 13D illustrates the air lock when the sample supported by the feeding rod is positioned in the vacuum chamber 91.

The air lock 1300 function is to allow loading / unloading into the vacuum chamber (denoted 91 in figure 10) numerous samples and technological accessories such as mask, calibrating plate, apertures, target for deposition etc without venting of a vacuum chamber 91.

The air lock 1300 includes:
a. A loading opening 1310 with a sliding sealing cover 1320 onto main housing 1330 for loading / unloading samples and technological accessories onto / from the feeding system (and from/onto a vacuum chamber that surrounds the manipulator).
b. A feeding system that includes a feeding rod 1305 that allows loading into the vacuum chamber 3-5 samples and technological accessories such as mask, calibrating plate, apertures, deposition target etc without additional venting of air-lock. The interface part (drum) of the feeding rod shall have numerous dove-tails for mounting on it standard shuttle carrying sample or a technological accessory. The Feeding rod 1305 can rotate about its axis and can be moved manually or by a motor.
c. A shut-off valve 1350 to prevent venting of the vacuum chamber during loading / unloading samples and technological accessories onto / from the feeding system.

The air lock 1300 is proximate to an opening in the wall 91(1) of the vacuum chamber 91 such that when the shut-off valve 1350 is opened the feeding rod 1305 can enter the vacuum chamber 91 and especially the interior space 91 (2) of the vacuum chamber 91. The Air lock 1300 and especially loading opening (space) are vacuumed before the feeding rod 1305 enters the vacuum chamber. When the shut-off valve 1350 is closed the air lock 1300 is sealed in a manner that prevents gases to enter the vacuum chamber 91.

The manipulator 100 can include the following stages and these stages can be characterized by the following parameters:

Main rotating stage 130:

| | |
|---|---|
| Actuator type: | Piezo motor |
| Actuation modes: | stepping & scanning |
| Stroke: | min 120 degrees |
| Maximal speed: | 10 degrees/s |
| Maximal acceleration: | 1000 degrees/s^2 |
| Positioning accuracy with encoder closed loop: | 150 m° |
| Resolution: | 50 microns |

First sub-unit 114:

| X-axis 100(1) | |
|---|---|
| Actuator type: | Piezo motor |
| Actuation modes: | stepping & scanning |
| Stroke: | 30 mm |
| Maximal speed: | 5 mm/s |
| Maximal acceleration: | 1000 mm/s^2 |
| Positioning accuracy with encoder closed loop: | 1000 nm |
| Resolution: | 1 nm |

| Y-axis 100(2) | |
|---|---|
| Actuator type: | Piezo motor |
| Actuation modes: | stepping & scanning |
| Stroke: | 25 mm |
| Maximal speed: | 10 mm/s |
| Maximal acceleration: | 1000 mm/s^2 |
| Positioning accuracy with encoder closed loop: | 1000 nm |
| Resolution: | 1 nm |

| Z-axis 100 (3) | |
|---|---|
| Actuator type: | Piezo motor |

| | |
|---|---|
| Actuation modes: | stepping & scanning |
| Stroke: | 30 mm |
| Maximal speed: | 5 mm/s |
| Maximal acceleration: | 1000 mm/s^2 |
| Positioning accuracy with encoder closed loop: | 1000 nm |
| Resolution: | 1 nm |

| θ-axis (may have no thru-hole in the axis) 100(5) | |
|---|---|
| Actuator type: | Piezo motor |
| Actuation modes: | stepping & scanning |
| Stroke: | 360 degrees |
| Maximal speed: | 45 degrees/s |
| Maximal acceleration: | 1000 degreesls^2 |
| Positioning accuracy with encoder closed loop: | 500 m° |
| Resolution: | 100 µ° |

Second sub-unit 120:

| X-axis 100(11) | |
|---|---|
| Actuator type: | Piezo motor |
| Actuation modes: | stepping & scanning |
| Stroke: | 30 mm |
| Maximal speed: | 5 mm/s |
| Maximal acceleration: | 1000 mm/s^2 |
| Positioning accuracy with encoder closed loop: | 1000 nm |
| Resolution: | 1 nm |

| Y-axis (not shown) | |
|---|---|
| Actuator type: | Piezo motor |
| Actuation modes: | stepping & scanning |
| Stroke: | 25 mm |
| Maximal speed: | 10 mm/s |
| Maximal acceleration: | 1000 mm/s^2 |
| Positioning accuracy with encoder closed loop: | 1000 nm |
| Resolution: | 1 nm |

| Z-axis 100(9) | |
|---|---|
| Actuator type: | Piezo motor |
| Actuation modes: | stepping & scanning |
| Stroke: | 30 mm |
| Maximal speed: | 5 mm/s |
| Maximal acceleration: | 1000 mm/s^2 |
| Positioning accuracy with encoder closed loop: | 1000 nm |
| Resolution: | 1 nm |

| R-axis 100(8) | |
|---|---|
| Actuator type: | Piezo motor |
| Actuation modes: | stepping & scanning |
| Stroke: | 360 degrees |
| Maximal speed: | 45 degrees/s |
| Maximal acceleration: | 1000 degrees/s^2 |
| Positioning accuracy with encoder closed loop: | 250 m° |
| Resolution: | 150 µ° |

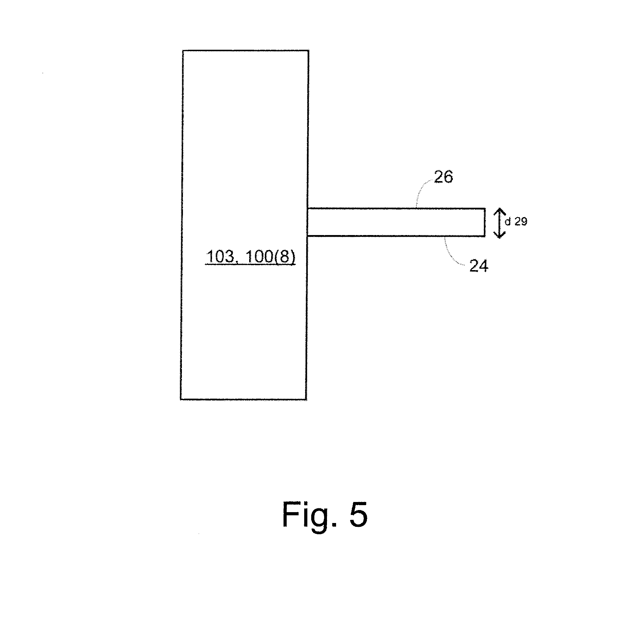

Referring to figures 1 and 5, the initial sample and the milled sample can be characterized by the following parameters:

| | | |
|---|---|---|
| Input sample thickness | | 20-30 microns |
| Milled sample thickness | | 10-50 nm |
| Thickness variation in area of interest | | <5nm |

| Thinned area around target feature (area of interest) | | |
|---|---|---|
| | Thickness <50 nm | 10 X 5 µ |
| | Thickness <100 nm | 30 X 10 µ |
| | Thickness <200 nm | 100 X 15 µ |
| Localization of area of interest | | 5-10 nm |

| Artifacts level | | |
|---|---|---|
| | Amorphisation | <1 nm |
| | Point defects | <1 nm |
| | Xe contamination | <10⁻⁹ % |

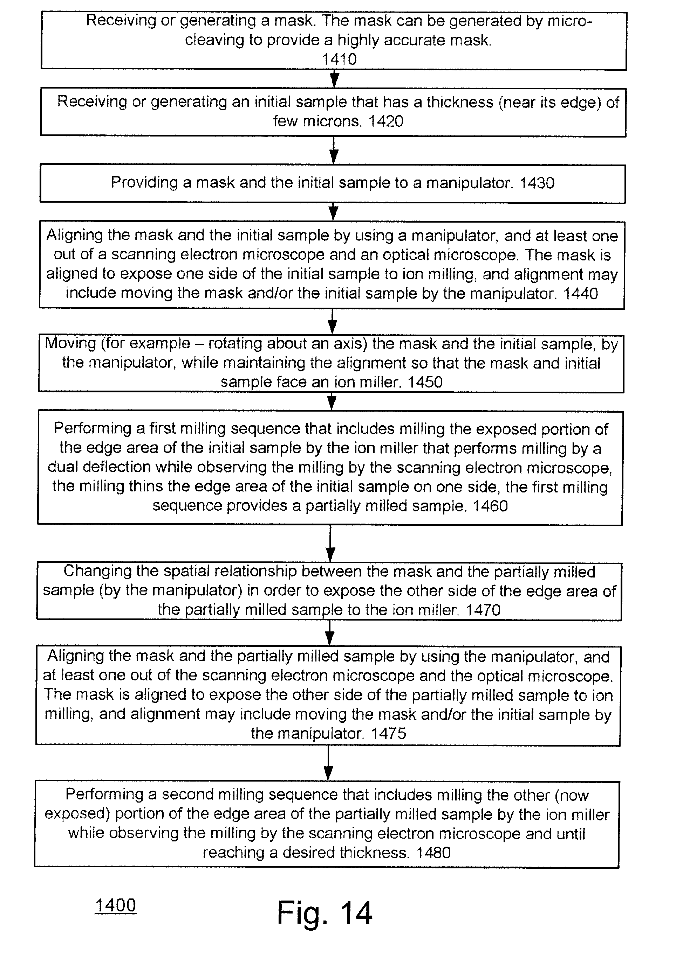

Figure 14 illustrates method 1400 according to an embodiment of the invention.

Method 1400 starts by stage 1410 of receiving or generating a mask. The mask can be generated by micro-cleaving to provide a highly accurate mask. An example for micro-cleaving is illustrated in US patent 6223961 titled "Apparatus for cleaving crystals", which is incorporated herein by reference.

Stage 1410 is followed by stage 1420 of receiving or generating an initial sample that has a thickness (near its edge) of few microns - as illustrated in figure 1. The initial sample can be prepared by an ME3 tool of Camtek Ltd. of Israel.

Stage 1420 is followed by stage 1430 of providing a mask and the initial sample to a manipulator.

Stage 1430 is followed by stage 1440 of aligning the mask and the initial sample (figure 2) by using a manipulator, and at least one out of a scanning electron microscope and an optical microscope. The mask is aligned to expose one side of the initial sample to ion milling, and alignment may include moving the mask and/or the initial sample by the manipulator.

Stage 1440 is followed by stage 1450 of moving (for example - rotating about an axis) the mask and the initial sample, by the manipulator, while maintaining the alignment so that the mask and initial sample face an ion miller.

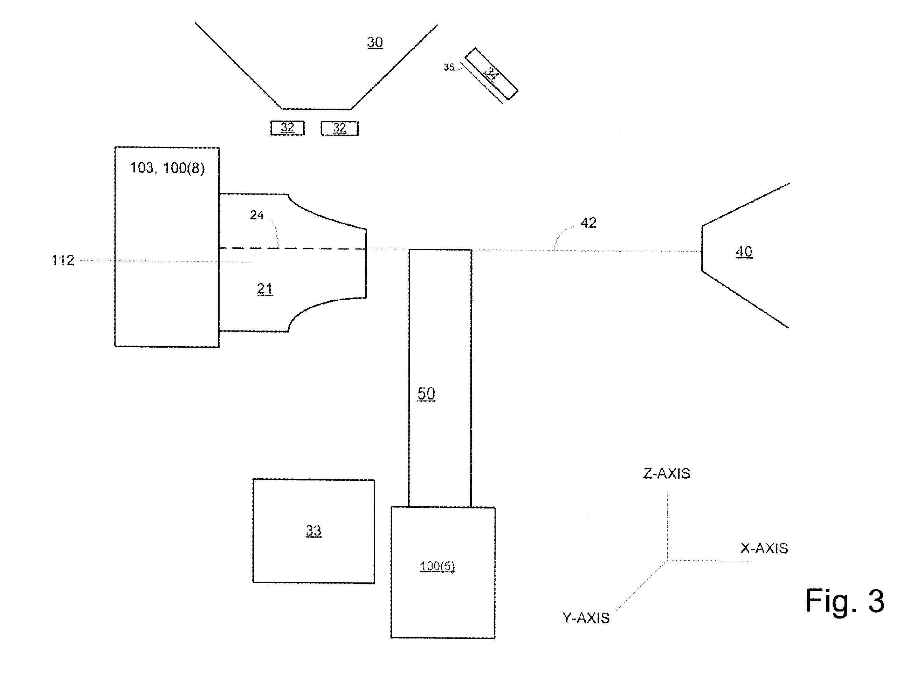

Stage 1450 is followed by stage 1460 of performing a first milling sequence (figure 3) that includes milling the exposed portion of the edge area of the initial sample by the ion miller that performs milling by a dual deflection while observing the milling by the scanning electron microscope, the milling thins the edge area of the initial sample on one side, the first milling sequence provides a partially milled sample; figure 2 illustrates that the mask exposed a zone that starts few nanometers (D 23) from the center of the initial sample.

Stage 1460 is followed by stage 1470 of changing the spatial relationship between the mask and the partially milled sample (by the manipulator) in order to expose the other side of the edge area of the partially milled sample to the ion miller.

Stage 1470 may be followed by stage 1475 of aligning the mask and the partially milled sample by using the manipulator, and at least one out of the scanning electron microscope and the optical microscope. The mask is aligned to expose the other side of the partially milled sample to ion milling, and alignment may include moving the mask and/or the initial sample by the manipulator.

Stage 1475 is followed by stage 1480 of performing a second milling sequence (figure 4) that includes milling the other (now exposed) portion of the edge area of the partially milled sample by the ion miller while observing the milling by the scanning electron microscope and (optionally - when the partially milled sample starts to be partially transparent to electrons) by a TEM or STEM detector, until reaching a desired thickness. The milling process can be automatically stopped when the TEM detector 33 indicates that the thickness of the milled sample reached the desired thickness.

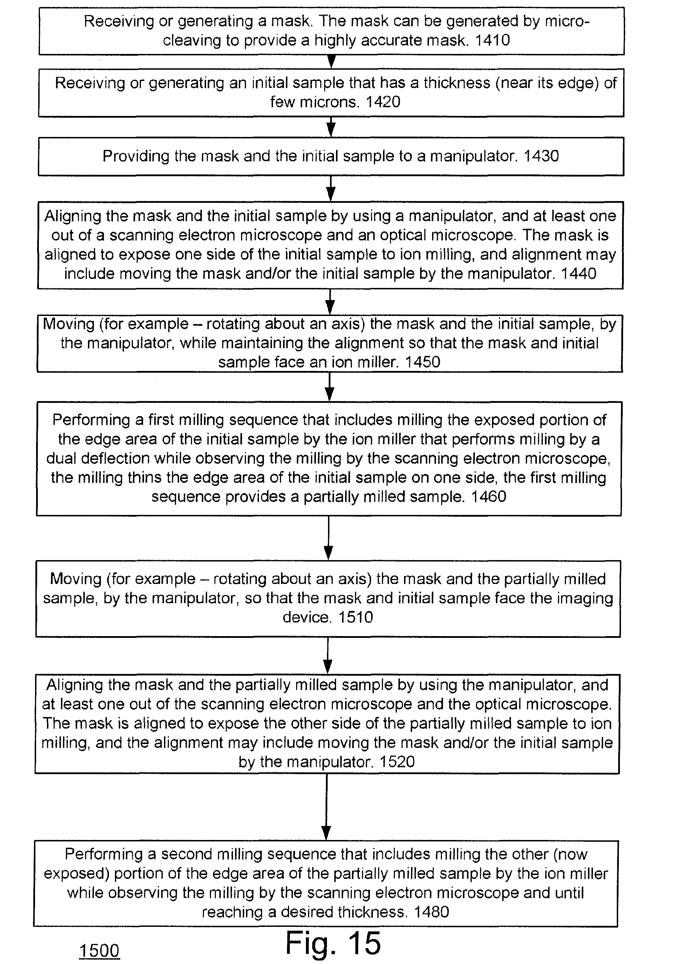

Figure 15 illustrates method 1500 according to an embodiment of the invention.

Method 1400 starts by stage 1410 of receiving or generating a mask. The mask can be generated by micro-cleaving to provide a highly accurate mask. An example for micro-cleaving is illustrated in US patent 6223961 titled "Apparatus for cleaving crystals", which is incorporated herein by reference.

Stage 1410 is followed by stage 1420 of receiving or generating an initial sample that has a thickness (near its edge) of few microns - as illustrated in figure 1. The initial sample can be prepared by an ME3 tool of Camtek Ltd. of Israel.

Stage 1420 is followed by stage 1430 of providing a mask and the initial sample to a manipulator.

Stage 1430 is followed by stage 1440 of aligning the mask and the initial sample (figure 2) by using a manipulator, and at least one out of a scanning electron microscope and an optical microscope. The mask is aligned to expose one side of the initial sample to ion milling, and alignment may include moving the mask and/or the initial sample by the manipulator.

Stage 1440 is followed by stage 1450 of moving (for example - rotating about an axis) the mask and the initial sample, by the manipulator, while maintaining the alignment so that the mask and initial sample face an ion miller.

Stage 1450 is followed by stage 1460 of performing a first milling sequence (figure 3) that includes milling the exposed portion of the edge area of the initial sample by the ion miller that performs milling by a dual deflection while observing the milling by the scanning electron microscope, the milling thins the edge area of the initial sample on one side, the first milling sequence provides a partially milled sample; figure 2 illustrates that the mask exposed a zone that starts few nanometers (D 23) from the center of the initial sample.

Stage 1460 is followed by stage 1510 of moving (for example - rotating about an axis) the mask and the partially milled sample, by the manipulator, so that the mask and initial sample face the imaging device.

Stage 1510 is followed by stage 1520 of aligning the mask and the partially milled sample by using the manipulator, and at least one out of the scanning electron microscope and the optical microscope. The mask is aligned to expose the other side of the partially milled sample to ion milling, and the alignment may include moving the mask and/or the initial sample by the manipulator.

Stage 1520 is followed by stage 1480 of performing a second milling sequence (figure 4) that includes milling the other (now exposed) portion of the edge area of the partially milled sample by the ion miller while observing the milling by the scanning electron microscope and (optionally - when the partially milled sample starts to be partially transparent to electrons) by a TEM or STEM detector, until reaching a desired thickness. The milling process can be automatically stopped when the TEM detector 33 indicates that the thickness of the milled sample reached the desired thickness. The milled sample (or at least its milled edge) should include the target to be viewed by the SETM or TEM.

It is noted that although figures 14 and 15 illustrate a dual milling process method that the method can include more than two milling stages that may be preceded by changing the spatial relationship between the mask and the sample and aligning the mask and the sample.

The outcome of each of the mentioned above methods may be a very thin area of interest that includes a target and is transparent to electrons so as to be a TEM or STEM sample.

The present invention can be practiced by employing conventional tools, methodology and components. Accordingly, the details of such tools, component and methodology are not set forth herein in detail. In the previous descriptions, numerous specific details are set forth, in order to provide a thorough understanding of the present invention. However, it should be recognized that the present invention might be practiced without resorting to the details specifically set forth.

Only exemplary embodiments of the present invention and but a few examples of its versatility are shown and described in the present disclosure. It is to be understood that the present invention is capable of use in various other combinations and environments and is capable of changes or modifications within the scope of the inventive concept as expressed herein.

## Claims

1. A method for preparing a sample, the method comprises:
receiving, by a manipulator, a mask and an initial sample;
positioning, by the manipulator, the mask and the initial sample in front of an imaging device so that the mask and a first side of an edge area of the initial sample face the imaging device;
aligning, by the manipulator, the mask and the initial sample so that the mask masks a masked portion of the edge area of the initial sample while maintaining an exposed portion of the edge area of the initial sample unmasked; wherein the aligning comprises obtaining images of the mask and the initial sample by the imaging device;
positioning, by the manipulator, the mask and the initial sample in front of an ion miller so that the mask and the first side of the edge area of the initial sample face the ion miller; while unchanging a spatial relationship between the mask and the initial sample;
milling, by the ion miller, the exposed portion of the edge area of the initial sample while masking the masked portion by the mask, to provide a partially milled sample;
positioning, by the manipulator, the mask and the initial sample in front of the imaging device so that the mask and a second side of the edge area of the initial sample face the imaging device; wherein the second side differs from the first side;
aligning, by the manipulator, the mask and the initial sample so that the mask masks a masked portion of the edge area of the partially milled sample while maintaining an exposed portion of the edge area of the partially milled sample unmasked; wherein the aligning comprises obtaining images of the mask and the partially milled sample by the imaging device;
positioning, by the manipulator, the mask and the partially milled sample in front of the ion miller so that the mask and the second side of the edge area of the partially milled sample face the ion miller, while unchanging a spatial relationship between the mask and the partially milled sample; and
milling, by the ion miller, the exposed portion of the edge area of the partially milled sample while masking the masked portion by the mask, to provide a milled sample.

2. The method according to claim 1, wherein the positioning, by the manipulator of the mask and the initial sample in front of the ion miller comprises rotating the mask and the initial sample by the manipulator.

3. The method according to claim 1, wherein the milling by the ion miller the exposed portion of the edge area of the partially milled sample comprises monitoring a thickness of the edge area of the milled sample, during the milling, by a transmissive detector of the imaging device.

4. The method according to claim 1, comprising changing a spatial relationship between the mask and the partially milled based on thickness feedback information obtained during the milling of the edge area of the partially milled sample.

5. The method according to claim 1, comprising changing a spatial relationship between the mask and the partially milled based on thickness feedback information obtained after the milling of the partially milled sample,

6. The method according to claim 1, wherein an imaging device optical axis is normal to a milling tool optical axis; and wherein the positioning, by the manipulator of the mask and the initial sample in front of the ion miller comprises rotating the mask and the initial sample by the manipulator.

7. The method according to claim 1, wherein the method comprises: positioning, by the manipulator, the mask and the initial sample so that the mask and a first side of the edge area of the initial sample are normal to an optical axis of the imaging device;
positioning, by the manipulator, the mask and the initial sample in front of an ion miller so that the mask and the first side of the edge area of the initial sample are normal to an optical axis of the ion miller;
positioning, by the manipulator, the mask and the initial sample in front of the imaging device so that the mask and a second side of the edge area of the initial sample are normal to an optical axis of the imaging device; and
positioning, by the manipulator, the mask and the partially milled sample in front of the ion miller so that the mask and the second side of the edge area of the partially milled sample are normal optical axis of the ion miller.

8. The method according to claim 1, wherein the edge area of the initial sample has a thickness of at least one micros and wherein thickness of the edge area of the milled sample does not exceed 50 nanometers.

9. The method according to claim 1, wherein the milling comprises milling while rotating a milling beam about the optical axis of the ion miller.

10. The method according to claim 1, comprising removing, by ion milling, the exposed portion of the edge area of the partially milled sample.

11. The method according to claim 1, comprising stopping the milling of the edge area of the partially milled sample based on a thickness of the edge area of the partially milled sample.

12. The method according to claim 11, comprising monitoring the thickness of the edge area of the partially milled sample by a transmissive detector of the imaging device.

13. The method according to claim 1, further comprising:
positioning, by the manipulator, the mask and the milled sample in front of the imaging device so that the mask and a first side of an edge area of the milled sample face the imaging device;
aligning, by the manipulator, the mask and the milled sample so that the mask masks a masked portion of the edge area of the milled sample while maintaining an exposed portion of the edge area of the milled sample unmasked; wherein the aligning comprises obtaining images of the mask and the milled sample by the imaging device;
positioning, by the manipulator, the mask and the milled sample in front of the ion miller so that the mask and the first side of the edge area of the milled sample face the ion miller; while unchanging a spatial relationship between the mask and the milled sample; and
milling, by the ion miller, the exposed portion of the edge area of the milled sample while masking the masked portion by the mask, to provide a further milled sample.

14. A sample preparation system, comprising:
a manipulator;
an imaging device; and
an ion miller;
wherein the manipulator is arranged to:
receive a mask and an initial sample;
position the mask and the initial sample in front of an imaging device so that the mask and a first side of an edge area of the initial sample face the imaging device;
participate in an alignment of the mask and the initial sample so that the mask masks a masked portion of the edge area of the initial sample while maintaining an exposed portion of the edge area of the initial sample unmasked;
position the mask and the initial sample in front of an ion miller so that the mask and the first side of the edge area of the initial sample face the ion miller; while unchanging a spatial relationship between the mask and the initial sample;
wherein the ion miller is arranged to mill the exposed portion of the edge area of the initial sample while masking the masked portion by the mask, to provide a partially milled sample;
wherein the manipulator is further arranged to :
position the mask and the initial sample in front of the imaging device so that the mask and a second side of the edge area of the initial sample face the imaging device; wherein the second side differs from the first side;
participate in an alignment of the mask and the partially milled sample so that the mask masks a masked portion of the edge area of the partially milled sample while maintaining an exposed portion of the edge area of the partially milled sample unmasked;
position the mask and the partially milled sample in front of the ion miller so that the mask and the second side of the edge area of the partially milled sample face the ion miller, while unchanging a spatial relationship between the mask and the partially milled sample;
wherein the ion miller is further adapted to mill the exposed portion of the edge area of the partially milled sample while masking the masked portion by the mask, to provide a milled sample; and
wherein the imaging device is arranged to:
obtain images of the mask and the initial sample during the alignment of the mask and the initial sample; and
obtain images of the mask and the partially milled sample during the alignment of the mask and the partially milled sample.

15. The system according to claim 14, manipulator is arranged to rotate the mask and the initial sample until the mask and the initial sample face the ion miller.
